# EUROPEAN PATENT APPLICATION

(11) **EP 3 869 639 A1**
(43) Date of publication of application: **25.08.2021**
(21) Application number: 19874166.2
(22) Date of filing: 18.10.2019
(51) Int. Cl.: H01S 5/024, H01L 23/28, H01L 33/64

(54) **OPTICAL ELEMENT MOUNTING PACKAGE, ELECTRONIC DEVICE, AND ELECTRONIC MODULE**

(30) Priority: 19.10.2018 JP 2018197507; 30.10.2018 JP 2018203476
(71) Applicant: Kyocera Corporation, Kyoto-shi, Kyoto 612-8501 (JP)
(72) Inventor: KITAGAWA, Akihiko, Kyoto-shi, Kyoto 612-8501 (JP); YAMASAKI, Sho, Kyoto-shi, Kyoto 612-8501 (JP)
(74) Representative: Viering, Jentschura & Partner mbB Patent- und Rechtsanwälte
(86) International application number: PCT/JP2019/041184
(87) International publication number: WO 2020/080539

(57) **Abstract**

Provided are an optical element mounting package, an electronic device, and an electronic module, which are capable of reducing the influence of heat generated from an optical element to an optical component. This optical element mounting package (101) and this electronic device (100) include a base body (110) having a recess (111) including a first mounting section (113a) on which an optical element (102) can be mounted and a second mounting section (113b) on which an optical component (103) can be mounted. The base body (110) further has a heat radiating section (120) located on the opposite side of the second mounting section (113b) with the first mounting section (113a) therebetween.

## Description

### Technical Field

The present disclosure relates to an optical element mounting package, an electronic device and an electronic module.

### Background Art

There has been a TO (Transistor Outline)-CAN semiconductor laser device. (See, for example, JPH 06-275920 A) .

### Summary of Invention

### Solution to Problem

An optical element mounting package of the present disclosure includes a base having
a recess including a first mounting portion where an optical element is mountable and a second mounting portion where an optical component is mountable, and
a heat radiating portion located opposite the second mounting portion with the first mounting portion in between.

An electronic device of the present disclosure employs a configuration including:
the above optical element mounting package;
the optical element mounted on the first mounting portion;
the optical component mounted on the second mounting portion; and
a lid joined to the optical element mounting package.

An electronic module of the present disclosure employs a configuration including:
the above electronic device; and
a module substrate where the electronic device is mounted.

### Advantageous Effects of Invention

According to the present disclosure, there can be provided an optical element mounting package, an electronic device and an electronic module that can reduce influence of heat that is generated in and added from an optical element to an optical component.

### Brief Description of Drawings

FIG. 1A is a vertical sectional view showing an optical element mounting package and an electronic device according to a first embodiment.
FIG. 1B is a plan view showing the optical element mounting package and the electronic device according to the first embodiment.
FIG. 2 is a diagram for explaining heat radiation of the optical element mounting package and the electronic device according to the first embodiment.
FIG. 3A is a sectional view showing an optical element mounting package and an electronic device according to a second embodiment.
FIG. 3B is a plan view showing the optical element mounting package and the electronic device according to the second embodiment.
FIG. 4A is a vertical sectional view showing an optical element mounting package and an electronic device according to a third embodiment.
FIG. 4B is a plan view showing the optical element mounting package and the electronic device according to the third embodiment.
FIG. 5 is a diagram for explaining heat radiation of the optical element mounting package and the electronic device according to the third embodiment.
FIG. 6A is a vertical sectional view showing an optical element mounting package and an electronic device according to a fourth embodiment.
FIG. 6B is a plan view showing the optical element mounting package and the electronic device according to the fourth embodiment.
FIG. 7A is a vertical sectional view showing an optical element mounting package and an electronic device according to a fifth embodiment.
FIG. 7B is a plan view showing the optical element mounting package and the electronic device according to the fifth embodiment.
FIG. 8A is a vertical sectional view showing an optical element mounting package and an electronic device according to a sixth embodiment.
FIG. 8B is a plan view showing the optical element mounting package and the electronic device according to the sixth embodiment.
FIG. 9 is a vertical sectional view showing an optical element mounting package, an electronic device and an electronic module according to a seventh embodiment.
FIG. 10 is a vertical sectional view showing an optical element mounting package, an electronic device and an electronic module according to an eighth embodiment.
FIG. 11 is a vertical sectional view showing a first example of an electronic module according to an embodiment.
FIG. 12A is a vertical sectional view showing a second example of the electronic module according to the embodiment.
FIG. 12B is a bottom view of an optical element mounting package of the second example of the electronic module according to the embodiment.
FIG. 13A is a vertical sectional view of a third example of the electronic module according to the embodiment.
FIG. 13B is a left side view of an optical element mounting package of the third example of the electronic module according to the embodiment.
FIG. 14A is a vertical sectional view showing an optical element mounting package and an electronic device according to a ninth embodiment.
FIG. 14B is a plan view showing the optical element mounting package and the electronic device according to the ninth embodiment.
FIG. 15 is a diagram for explaining heat radiation of the optical element mounting package and the electronic device according to the ninth embodiment.
FIG. 16A is a vertical sectional view showing an optical element mounting package and an electronic device according to a tenth embodiment.
FIG. 16B is a plan view showing the optical element mounting package and the electronic device according to the tenth embodiment.
FIG. 17 is a plan view showing a modification of the optical element mounting package and the electronic device of the tenth embodiment.
FIG. 18A is a vertical sectional view showing an optical element mounting package and an electronic device according to an eleventh embodiment.
FIG. 18B is a plan view showing the optical element mounting package and the electronic device according to the eleventh embodiment.
FIG. 19 is a plan view showing a modification of the optical element mounting package and the electronic device of the eleventh embodiment.
FIG. 20A is a vertical sectional view showing an optical element mounting package and an electronic device according to a twelfth embodiment.
FIG. 20B is a plan view showing the optical element mounting package and the electronic device according to the twelfth embodiment.
FIG. 21 is a vertical section showing a first example of an electronic module according to an embodiment.
FIG. 22 is a vertical section showing a second example of the electronic module according to the embodiment.
FIG. 23 is a vertical section showing a third example of the electronic module according to the embodiment.

### Description of Embodiments

Hereinafter, embodiments of the present disclosure will be described in detail with reference to the drawings.

### (First Embodiment)

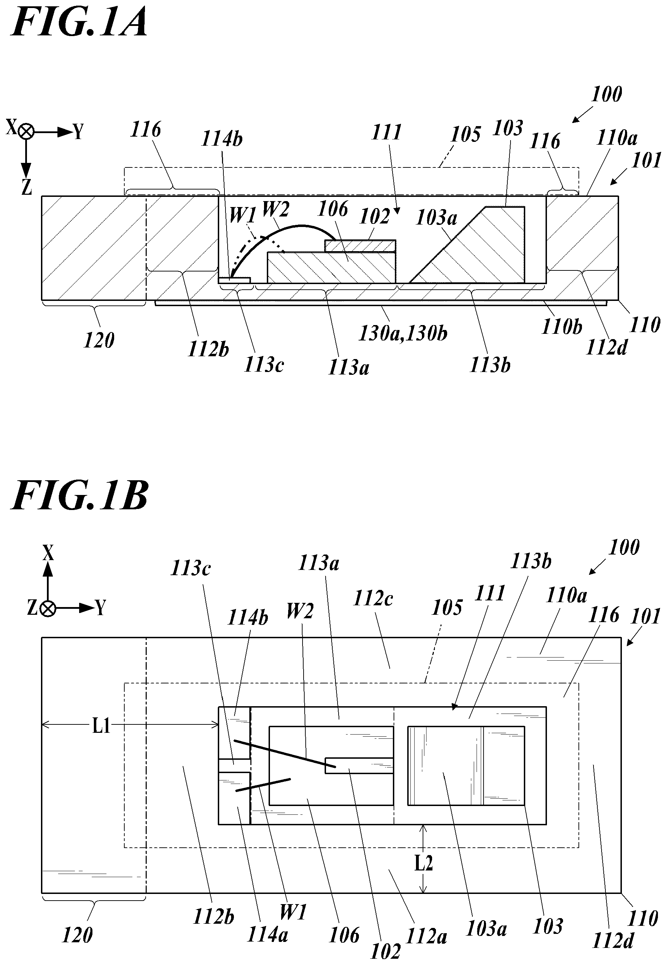

FIG. 1A and FIG. 1B show an optical element mounting package and an electronic device according to a first embodiment. FIG. 1A is a vertical sectional view, and FIG. 1B is a plan view. Hereinafter, directions of an optical element mounting package 101 may be expressed by using directions of three orthogonal axes X, Y, Z shown in the drawings. The Z direction corresponds to the depth direction of a recess 111 provided in the optical element mounting package 101. Up and down, high and low, front and back, and right and left may be expressed by regarding the Z direction as the downward direction, the reversed Z direction as the upward direction, directions along the X axis as the front and back directions, and directions along the Y axis as the right and left directions. The front, back, right, left, up and down referred to in this description/specification may be different from those if an electronic device is installed in an electronic module.

### <Optical Element Mounting Package>

The optical element mounting package 101 of the first embodiment is a surface-mount package, and includes: a base 110 having the recess 111 and a heat radiating portion 120; and wiring conductors 130a, 130b that are electrically connected to the outside.

The base 110 has an upper surface (first surface) 110a, a lower surface (second surface) 110b on the opposite side, and the recess 111 that is open in the upper surface 110a. The upper surface 110a of the base 110 includes a sealing portion 116 to which a lid 105 is connectable. The base 110 is an insulator, such as ceramic, and may have, inside, a wiring that electrically connects electrodes 114a, 114b in the recess 111 to the wiring conductors 130a, 130b on the outer surface.

The recess 111 is surrounded by the inner surface of a side wall and the inner bottom surface, and is open in its upper side. The side wall includes: a front side wall portion 112a and a back side wall portion 112c disposed on one side and the other side in the X direction; and a left side wall portion 112b and a right side wall portion 112d disposed on one side and the other side in the Y direction. The inner bottom surface includes a first mounting portion 113a where an optical element (e.g. laser diode) 102 that is electrically driven is to be mounted, a second mounting portion 113b where an optical component (e.g. mirror) 103 is to be mounted, and an electrode portion 113c. The first mounting portion 113a and the second mounting portion 113b are different from one another in position in the Y direction if viewed in the Z direction. Although not particularly limited, the electrode portion 113c is located opposite the second mounting portion 113b with the first mounting portion 113a in between. On the electrode portion 113c, the electrodes 114a, 114b to be electrically connected to the optical element 102 are disposed.

The base 110 has the heat radiating portion 120 located opposite the second mounting portion 113b with the first mounting portion 113a in between. The heat radiating portion 120 is, in a section as shown in FIG. 1A, of the side wall on the first mounting portion 113a side, a portion away from the inner wall on the first mounting portion 113a side over the thickness of the right side wall portion 112d (length thereof in the Y direction) on the second mounting portion 113b side. In FIG. 1A, of the side wall on the first mounting portion 113a side, a portion having the thickness of the right side wall portion 112d is shown as the left side wall portion 112b, and a portion over the thickness of the right side wall portion 112d is shown as the heat radiating portion 120.

The sealing portion 116 is a partial region of the upper surface 110a of the base 110, and surrounds the opening of the recess 111 in the shape of a ring. The peripheral portion of the lid 105 is joined to the sealing portion 116 with (via), for example, a joining material. In the first embodiment, the left end of the sealing portion 116 may be on the upper surface of the heat radiating portion 120.

The heat radiating portion 120 can guide heat of the first mounting portion 113a to the outside of the base 110, so that heat to be conducted from the first mounting portion 113a to the second mounting portion 113b is reduced as compared with a configuration having no heat radiating portion 120. It can be said that the heat radiating portion 120 protrudes, at a site opposite the second mounting portion 113b with the first mounting portion 113a in between, from the left side wall portion 112b of the base 110 in a direction (Y direction) from the second mounting portion 113b toward the first mounting portion 113a. Hereinafter, the heat radiating portion 120 may be referred to as a protrusion 120.

The protrusion 120 is, to be more specific, integrated with the left side wall portion (first side wall portion) 112b of the base 110, and protrudes leftward from the left side wall portion 112b. The left side wall portion 112b corresponds to a portion from the left inner side surface of the recess 111 up to a thickness of a prescribed wall thickness plus a variation in wall thickness design (e.g. prescribed wall thickness + 120%). A portion protruding leftward from the left inner side surface of the recess 111 over the wall thickness of the left side wall portion 112b is the protrusion 120. The above prescribed wall thickness may be a thickness of the minimum thickness for bearing the load that the optical element mounting package 101 is required to withstand plus an extra thickness, for example. The prescribed wall thickness may be the thickness of the thinnest wall of a portion functioning only as a partition from the outside among the front side wall portion 112a, the back side wall portion 112c and the right side wall portion 112d.

The protrusion 120 has the following protruding amount. That is, the protruding amount is the amount that makes the maximum thickness L1 (FIG. 1B), which is the thickness of the protrusion 120 integrated with the left side wall portion 112b, at least twice the minimum wall thickness L2 (FIG. 1B) of the side wall. In other words, the maximum thickness L1 from the inner surface of the left side wall portion 112b to the surface on the protruding side of the protrusion 120 is at least twice the minimum wall thickness L2 among the thicknesses of the front side wall portion 112a, the back side wall portion 112c and the right side wall portion 112d.

Although not particularly limited, the wiring conductors 130a, 130b are disposed on the lower surface 110b of the base 110, and electrically connected to the electrodes 114a, 114b in the recess 111. The wiring conductors 130a, 130b may be entirely or partly located on the lower surface of the protrusion 120.

### <Electronic Device>

The electronic device 100 of the first embodiment includes, as shown in FIG. 1, the optical element mounting package 101, the optical element 102, the optical component 103, the lid 105 and a submount 106.

The optical element 102 is, for example, a laser diode, and to be mounted on the first mounting portion 113a of the base 110 via the submount 106. The submount 106 is a stand interposed between the optical element 102 and the first mounting portion 113a, and may be omitted. The submount 106 brings about an effect of diffusing heat generated in the optical element 102, an effect of raising the optical axis of the optical element 102, and an effect of relieving stress applied to the optical element 102 due to thermal expansion difference between the optical element 102 and the base 110. The submount 106 has an electrical wiring for an electrode of the optical element 102 and the electrode 114a of the base 110. The optical element 102 is to be mounted in such a way as to emit laser light toward the optical component 103 on the right side. Two electrodes of the optical element 102 are electrically connected to the electrodes 114a, 114b via connecting members W1, W2, such as bonding wires.

The optical component 103 is, for example, a mirror, and to be mounted on the second mounting portion 113b of the base 110, and has a reflection surface 103a inclined with respect to the upper surface 110a of the base 110. The optical component 103 reflects the laser light, which the optical element 102 has emitted rightward, upward with the reflection surface 103a. The optical component 103 is configured, for example, by forming a reflective film on, for example, glass, resin or a metal plate. The optical component 103 may have a property that characteristics are changed by heat.

The lid 105 is a plate-like translucent member, and its peripheral portion is joined to the sealing portion 116 of the base 110 with a joining material. With the lid 105, the recess 111 is sealed (covered). The lid 105 may have a property that characteristics are changed by heat. In the first embodiment, the lid 105 may extend to above the protrusion 120, or a portion of the lid 105 may be joined to the upper surface of the protrusion 120 with a joining material.

### <Description of Operation>

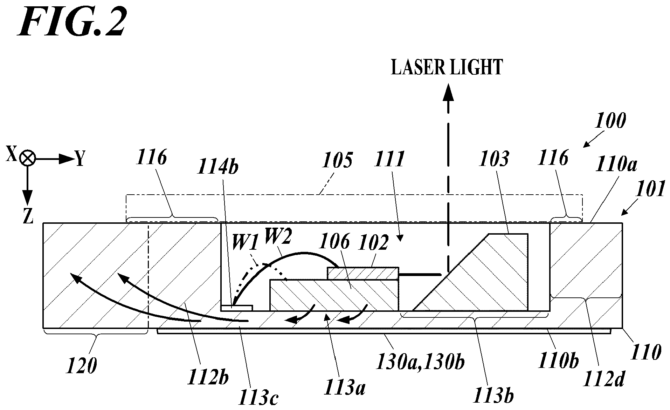

FIG. 2 is a diagram for explaining heat radiation of the optical element mounting package and the electronic device according to the first embodiment.

If a voltage is input to the optical element 102 via the wiring conductors 130a, 130b of the electronic device 100, the optical element 102 is driven. If the optical element 102 is driven, laser light is emitted from the optical element, is reflected by the optical component 103, and passes through the lid 105, thereby exiting to the outside of the electronic device 100.

If the optical element 102 is driven, the optical element 102 generates heat. Most of the heat diffuses from the first mounting portion 113a to the bottom of the base 110 via the submount 106 (directly if the submount 106 is not provided), and part of the heat diffuses to the bottom of the base 110 via the connecting members W1, W2 and the electrode portion 113c.

Since the optical element mounting package 101 has the protrusion 120, a large heat capacity is ensured on the left side of the first mounting portion 113a. Hence, as indicated by arrows in FIG. 2, much of the heat diffused from the first mounting portion 113a to the bottom of the base 110 diffuses to the protrusion 120, and, after diffusing thereto, is released from the protrusion 120 to the outside of the electronic device 100. That is, as compared with the case of no protrusion 120, having the protrusion 120 suppresses conduction of heat from the bottom of the base 110 to the optical component 103 via the second mounting portion 113b.

As described above, according to the optical element mounting package 101 and the electronic device 100 of the first embodiment, providing the base 110 with the recess 111 where the optical element 102 and the optical component 103 are to be mounted yields the surface-mount package and electronic device 100. According to the surface-mount optical element mounting package 101 and electronic device 100, since their outer surfaces are joined to a module substrate surface-to-surface, even if they are small, high heat radiation performance is obtained. Further, according to the optical element mounting package 101 and the electronic device 100 of the first embodiment, the protrusion 120 located on the left side of the first mounting portion 113a can, as described above, suppress conduction of heat of the optical element 102 to the optical component 103. Hence, even if the amount of heat generated in the optical element 102 increases, the heat of the optical element 102 is promptly released, which suppresses deterioration of optical characteristics of the optical element 102 itself due to the heat. Still further, it is possible to suppress deformation of the optical component 103 due to the heat conducted from the optical element 102 to the optical component 103, and accordingly suppress deterioration of optical characteristics of the electronic device 100. These make it possible to maintain stable optical characteristics.

### (Second Embodiment)

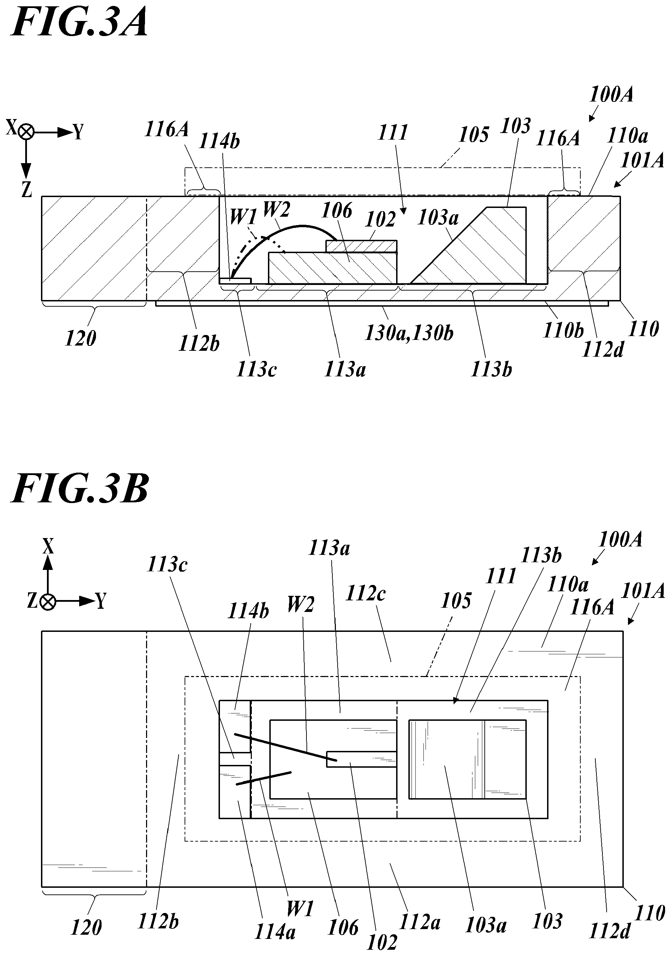

FIG. 3A and FIG. 3B show an optical element mounting package and an electronic device according to a second embodiment. FIG. 3A is a vertical sectional view, and FIG. 3B is a plan view.

An optical element mounting package 101A and an electronic device 100A of the second embodiment are different from those of the first embodiment mainly in a positional relationship between a sealing portion 116A where the lid 105 is to be mounted and the protrusion 120. The components same as those of the first embodiment are denoted by the same reference signs as those in the first embodiment, and detailed descriptions thereof are omitted.

The optical element mounting package 101A includes the base 110 having the recess 111, the sealing portion 116A and the protrusion 120.

The sealing portion 116A is located on the upper surface 110a of the base 110, not extending to above the protrusion 120. The position of the sealing portion 116A may be recognized by plating or marking an area where a joining material or the lid 105 is placed. Alternatively, the position of the sealing portion 116A may be recognized from specifications or the like showing an area where a joining material or the lid 105 is placed.

The protrusion 120 protrudes leftward from the left side wall portion 112b as in the first embodiment. The protrusion 120 is located outside the sealing portion 116A if viewed in the Z direction. The protrusion 120 of the second embodiment may or may not satisfy the condition for the protruding amount of the protrusion 120 of the first embodiment.

The electronic device 100A includes the optical element mounting package 101A, the optical element 102, the optical component 103, the lid 105 and the submount 106. The lid 105 is joined to the sealing portion 116A. If viewed in the Z direction, the lid 105 and the protrusion 120 are separate from one another.

As described above, according to the optical element mounting package 101A and the electronic device 100A of the second embodiment, as in the first embodiment, high heat radiation performance and the effect of reducing the amount of heat that is conducted from the optical element 102 to the optical component 103 can be obtained. Further, in the second embodiment, the lid 105 is separate from the protrusion 120. This can reduce conduction of heat of the optical element 102 to the lid 105 via the protrusion 120, and accordingly can suppress deterioration of the optical characteristics due to the lid 105 being influenced by heat.

### (Third Embodiment)

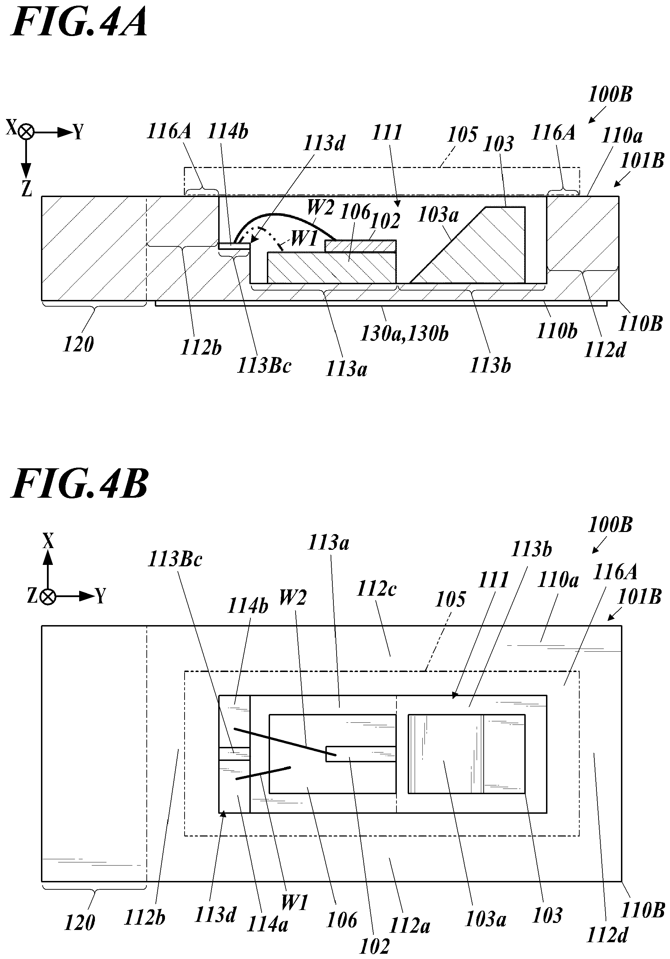

FIG. 4A and FIG. 4B show an optical element mounting package and an electronic device according to a third embodiment. FIG. 4A is a vertical sectional view, and FIG. 4B is a plan view.

An optical element mounting package 101B and an electronic device 100B of the third embodiment are different from those of the first and second embodiments mainly in configuration of an electrode portion 113Bc. The components same as those of the first and/or second embodiment(s) are denoted by the same reference signs as those in the first and/or second embodiment(s), and detailed descriptions thereof are omitted.

The optical element mounting package 101B includes: a base 110B having the recess 111, the sealing portion 116A and the protrusion 120; and the wiring conductors 130a, 130a.

The recess 111 includes a step portion 113d located opposite the second mounting portion 113b with the first mounting portion 113a in between. The step portion 113d is higher than the first mounting portion 113a but lower than the upper surface 110a including the sealing portion 116A. The region of the upper surface of the step portion 113d corresponds to the electrode portion 113Bc, and the electrodes 114a, 114b are disposed on the electrode portion 113Bc.

The electronic device 100B according to the third embodiment includes the optical element mounting package 101B, the optical element 102, the optical component 103, the lid 105 and the submount 106. The optical element 102 or the submount 106 is at about the same level as the step portion 113d. The electrodes of the optical element 102 are electrically connected to the electrodes 114a, 114b on the step portion 113d via the connecting members W1, W2, such as bonding wires.

### <Description of Operation>

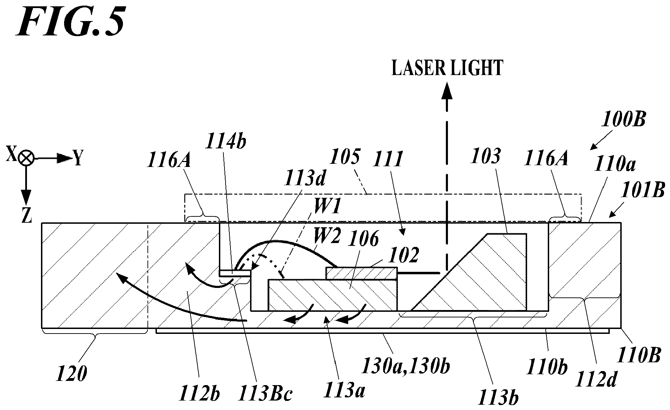

FIG. 5 is a diagram for explaining heat radiation of the optical element mounting package and the electronic device according to the third embodiment.

If the optical element 102 generates heat, part of the heat diffuses from the first mounting portion 113a to the bottom of the base 110B via the submount 106 (directly if the submount 106 is not provided), and part of the heat diffuses to the step portion 113d of the base 110B via the connecting members W1, W2 and the electrode portion 113Bc. Meanwhile, since the base 110B includes the protrusion 120, which has a large heat capacity, on the left side, much of the heat diffused to the step portion 113d and the bottom of the base 110B is conducted to the protrusion 120, and accordingly the amount of heat that is conducted toward the second mounting portion 113b is reduced. This reduces conduction of heat of the optical element 102 to the optical component 103.

As described above, according to the optical element mounting package 101B and the electronic device 100B of the third embodiment, as in the first embodiment, high heat radiation performance and the effect of reducing the amount of heat that is conducted from the optical element 102 to the optical component 103 can be obtained. Further, in the third embodiment, the electrode portion 113Bc to which heat is conducted from the connecting members W1, W1 is disposed on the step portion 113d. This can further reduce conduction of heat from the electrode portion 113Bc to the second mounting portion 113b. Hence, even if the amount of heat generated in the optical element 102 is large, it is possible to further suppress deterioration of the optical characteristics of the optical element 102 and the optical component 103 due to heat.

### (Fourth Embodiment)

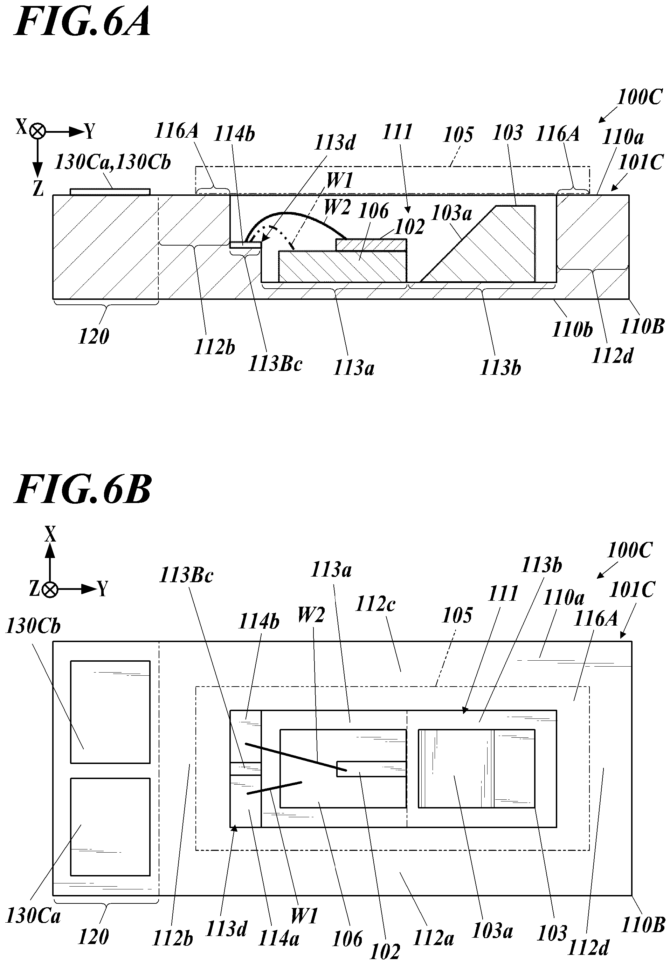

FIG. 6A and FIG. 6B show an optical element mounting package and an electronic device according to a fourth embodiment. FIG. 6A is a vertical sectional view, and FIG. 6B is a plan view.

An optical element mounting package 101C and an electronic device 100C of the fourth embodiment are different from those of the third embodiment mainly in arrangement of wiring conductors 130Ca, 130Cb. The components same as those of the third embodiment are denoted by the same reference signs as those in the third embodiment, and detailed descriptions thereof are omitted.

The optical element mounting package 101C includes: the base 110B having the recess 111, the sealing portion 116A and the protrusion 120; and the wiring conductors 130Ca, 130Ca.

The wiring conductors 130Ca, 130Cb are planar or plate-like conductors, and disposed on the upper surface of the protrusion 120. The wiring conductors 130Ca, 130Cb may be conductors electrically connected to the electrodes 114a, 114b in the recess 111, or may be dummy wiring conductors where current does not flow. If the wiring conductors 130Ca, 130Cb are dummy wiring conductors, other wiring conductors may be disposed on the outer surface of another portion of the base 110B, and the electrodes 114a, 114b in the recess 111 may be electrically connected to these wiring conductors.

The sealing portion 116A is disposed on the right side of the wiring conductors 130Ca, 130Cb and does not lie on the wiring conductors 130Ca, 130Cb.

The electronic device 100C includes the optical element mounting package 101C, the optical element 102, the optical component 103, the lid 105 and the submount 106. The lid 105 is joined to the sealing portion 116A. If viewed in the Z direction, the lid 5 and the wiring conductors 130Ca, 130Cb do not lie on top of one another.

As described above, according to the optical element mounting package 101C and the electronic device 100C of the fourth embodiment, as in the first embodiment, high heat radiation performance and the effect of reducing the amount of heat that is conducted from the optical element 102 to the optical component 103 can be obtained. Further, in the fourth embodiment, the wiring conductors 130Ca, 130Cb are disposed on the protrusion 120. This can efficiently release heat conducted to the protrusion 120 from the wiring conductors 130Ca, 130Cb to the outside, and accordingly suppress accumulation of heat in the protrusion 120. For example, if the wiring conductors 130Ca, 130Cb are joined to connecting pads of a module substrate, heat can be released to the module substrate, whereas if a heat sink is joined to the wiring conductors 130Ca, 130Cb, heat can be released to the heat sink. Even if nothing is connected to the wiring conductors 130Ca, 130Cb, heat can be efficiently released by radiation or the like. These can further reduce the influence of heat generated in the optical element 102 on the optical element 102 and the optical component 103, and can maintain the optical characteristics of the electronic device 100C more stably.

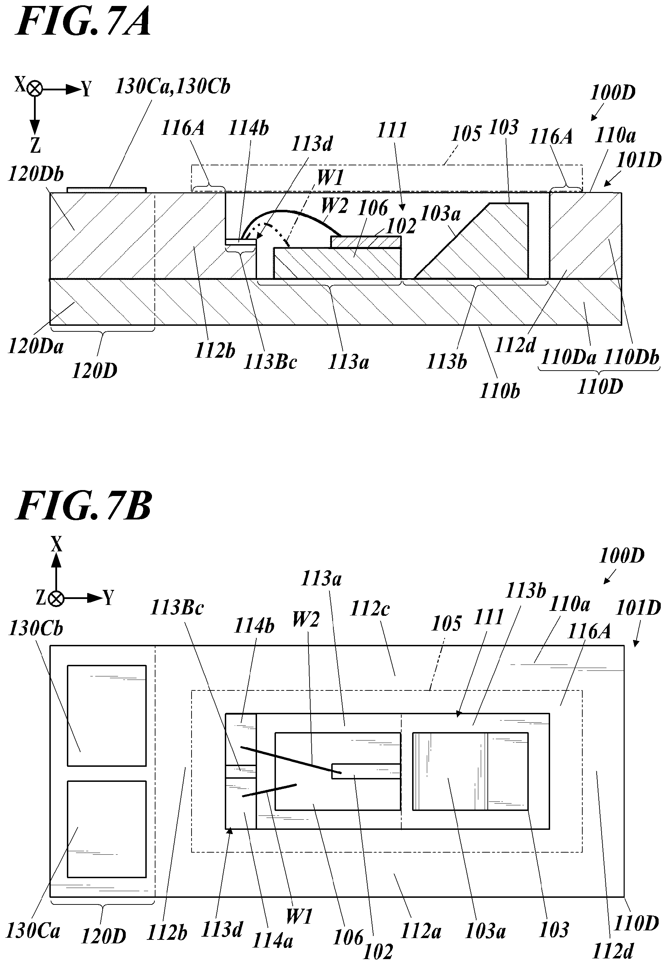

FIG. 7A and FIG. 7B show an optical element mounting package and an electronic device according to a fifth embodiment. FIG. 7A is a vertical sectional view, and FIG. 7B is a plan view.

An optical element mounting package 101D and an electronic device 100D of the fifth embodiment are different from those of the third embodiment in that materials of a base 110D and a protrusion 120D included in the base 110D are partly changed. The components same as those of the third embodiment are denoted by the same reference signs as those in the third embodiment, and detailed descriptions thereof are omitted.

The optical element mounting package 101D includes: the base 110D having the recess 111, the sealing portion 116A and the protrusion 120D; and the wiring conductors 130Ca, 130Ca.

The base 110D includes: metal portions 110Da, 120Da composed of a metal as a high heat radiating material, such as copper or aluminum, or an alloy having any of these as a main component; and insulating portions 110Db, 120Db composed of an insulator, such as ceramic. The metal portions 110Da, 120Da occupy the lower portion(s) of the base 110D and the protrusion 120D included in the base 110D. The insulating portions 110Db, 120Db occupy the portion(s) above the metal portions 110Da, 120Da. The metal portions 110Da, 120Da occupy the portion(s) lower than the height (level) of the inner bottom surface of the recess 111. The first mounting portion 113a and the second mounting portion 113b may have mounting surfaces where the metal portion is exposed, and further have the surfaces plated. Except the above, the base 110D is the same as that of the third embodiment in form.

The electronic device 100D includes the optical element mounting package 101D, the optical element 102, the optical component 103, the lid 105 and the submount 106. The optical element 102 is to be mounted, via the submount 106, on the first mounting portion 113a where the metal portion is exposed. The optical component 103 is to be mounted on the second mounting portion 113b where the metal portion is exposed. The surfaces of the first mounting portion 113a and the second mounting portion 113b may be plated.

As described above, according to the optical element mounting package 101D and the electronic device 100D of the fifth embodiment, as in the first embodiment, high heat radiation performance and the effect of reducing the amount of heat that is conducted from the optical element 102 to the optical component 103 can be obtained. Further, in the fifth embodiment, the metal portions 110Da, 120Da increase the heat capacity(ies) and the radiation amount(s) of the base 110D and the protrusion 120D included in the base 110D. This suppresses temperature increase of the electronic device 100D as a whole due to heat generated in the optical element 102, and hence can further reduce the influence of heat generated in the optical element 102 on the optical element 102 and the optical component 103, and can maintain the optical characteristics more stably.

### (Sixth Embodiment)

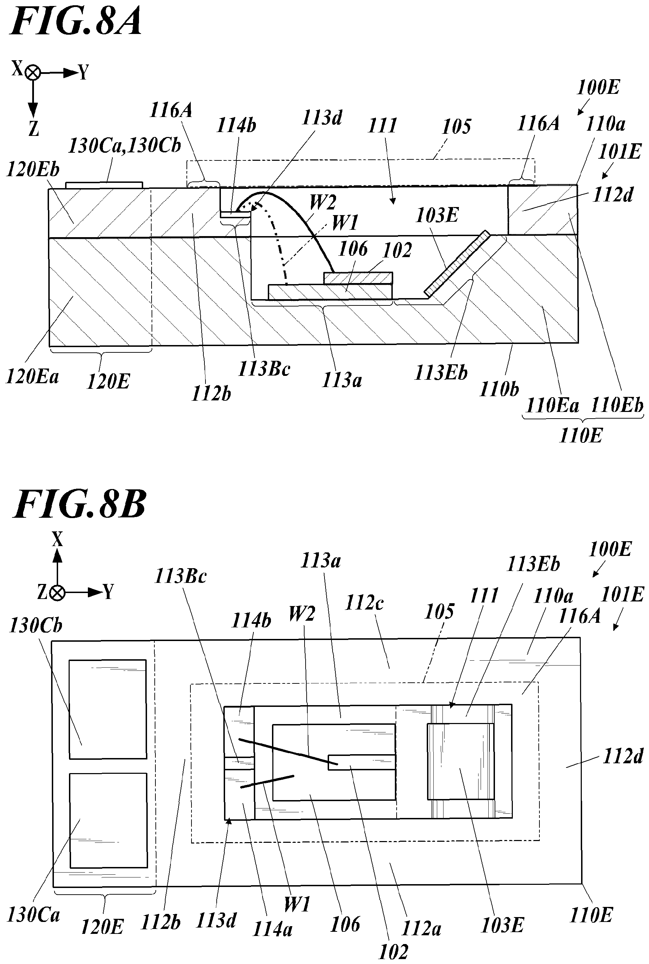

FIG. 8A and FIG. 8B show an optical element mounting package and an electronic device according to a sixth embodiment. FIG. 8A is a vertical sectional view, and FIG. 8B is a plan view.

An optical element mounting package 101E and an electronic device 100E of the sixth embodiment are different from those of the third embodiment in form of a second mounting portion 113Eb and in that materials of a base 110E and a protrusion 120E included in the base 110E are partly changed. The components same as those of the third embodiment are denoted by the same reference signs as those in the third embodiment, and detailed descriptions thereof are omitted.

The optical element mounting package 101E includes: the base 110E having the recess 111, the sealing portion 116A and the protrusion 120E; and the wiring conductors 130Ca, 130Cb. The recess 111 includes the second mounting portion 113Eb where an optical component 103E is to be mounted. The second mounting portion 113Eb is inclined in such a way as to be closer to the upper surface 110a of the base 110E as it is more distant from the first mounting portion 113a.

The base 110E includes: metal portions 110Ea, 120Ea composed of a metal as a high heat radiating material, such as copper or aluminum, or an alloy having any of these as a main component; and insulating portions 110Eb, 120Eb composed of an insulator, such as ceramic. The metal portions 110Ea, 120Ea occupy the lower portion(s) of the base 110E and the protrusion 120E included in the base 110E. The insulating portions 110Eb, 120Eb occupy the portion(s) above the metal portions 110Ea, 120Ea. The metal portions 110Ea, 120Ea occupy the portion(s) lower than a position (level) corresponding to the upper end of the slope of the second mounting portion 113Eb and lower than the upper surface of the step portion 113d.

The electronic device 100E includes the optical element mounting package 101E, the optical element 102, the optical component 103E, the lid 105 and the submount 106. The optical component 103E is a plate-like mirror, and reflects laser light, which the optical element 102 has emitted rightward, upward. The optical component 103 is configured, for example, by forming a reflective film on, for example, glass, resin or a metal plate. The optical element 102 is to be mounted, via the submount 106, on the first mounting portion 113a where the metal portion is exposed. The optical component 103E is to be mounted on the second mounting portion 113Eb where the metal portion is exposed. The surfaces of the first mounting portion 113a and the second mounting portion 113Eb may be plated.

As described above, according to the optical element mounting package 101E and the electronic device 100E of the sixth embodiment, as in the first embodiment, high heat radiation performance and the effect of reducing the amount of heat that is conducted from the optical element 102 to the optical component 103E can be obtained. Further, in the sixth embodiment, an effect of making the optical component 103E small and reducing the Y-direction dimension of the electronic device 100E can be obtained. If the optical component 103E is small, even if the diffusion amount of heat to the optical component 103E is relatively small, temperature change of the optical component 103E is large. However, according to the configuration of the sixth embodiment, the metal portions 110Ea, 120Ea increase the heat capacity(ies) and the radiation amount(s) of the base 110E and the protrusion 120E included in the base 110E. This suppresses temperature increase of the electronic device 100E as a whole due to heat generated in the optical element 102, and can further reduce the diffusion amount of heat to the optical component 103E, and hence can maintain the optical characteristics stably even if the optical component 103E is small.

### (Seventh Embodiment)

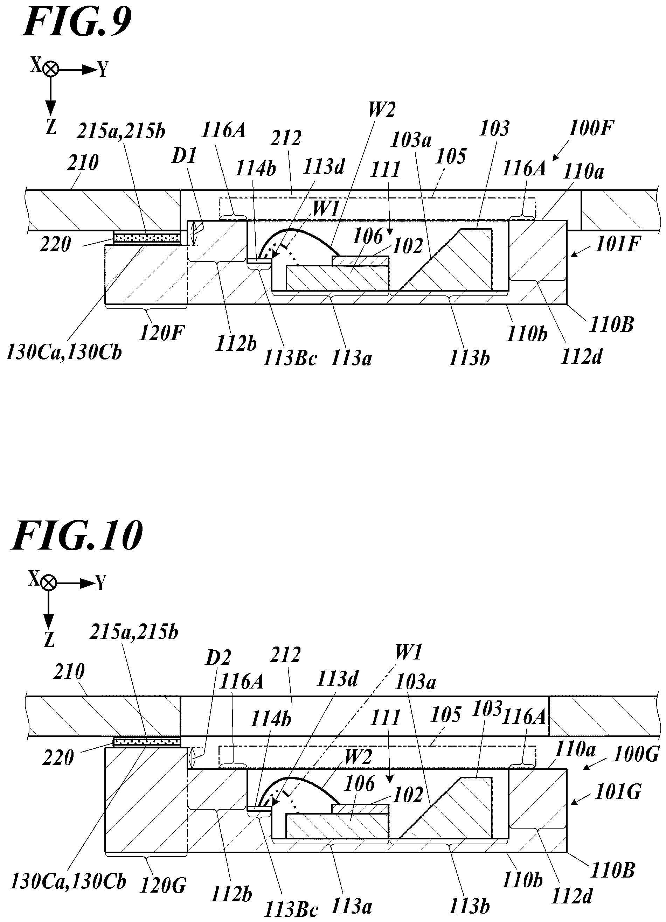

FIG. 9 is a vertical sectional view showing an optical element mounting package, an electronic device and an electronic module according to a seventh embodiment.

An optical element mounting package 101F and an electronic device 100F of the seventh embodiment are different from those of the third embodiment mainly in form of a protrusion 120F. The components same as those of the third embodiment are denoted by the same reference signs as those in the third embodiment, and detailed descriptions thereof are omitted.

The optical element mounting package 101F includes: the base 110B having the recess 111, the sealing portion 116A and the protrusion 120F; and the wiring conductors 130Ca, 130Cb. The protrusion 120F protrudes leftward from the left side wall portion 112b. Between the protrusion 120F and the left side wall portion 112b, a level difference D1 is provided. The level difference D1 is present on the upper surface 110a of the base 101B, and the upper surface of the protrusion 120F is lower than the upper surface of the other portion, which is not the protrusion 120F. There may be a similar level difference(s) between the front surface of the protrusion 120F and the front surface of the other portion, which is not the protrusion 120F, of the base 110B and/or between the back surface of the protrusion 120F and the back surface of the other portion, which is not the protrusion 120F, of the base 110B.

The wiring conductors 130Ca, 130Cb are disposed on the upper surface of the protrusion 120F, the upper surface being lower by the level difference D1.

The electronic device 100F includes the optical element mounting package 101F, the optical element 102, the optical component 103, the lid 105 and the submount 106.

According to the optical element mounting package 101F and the electronic device 100F of the seventh embodiment, in addition to the effects of the third embodiment, there is an advantage that if the electronic device 100F is to be mounted on a module substrate 210, the electronic device 100F can be easily positioned by utilizing the level difference D1, such that light to exit from the lid is not blocked.

### (Eighth Embodiment)

FIG. 10 is a vertical sectional view showing an optical element mounting package, an electronic device and an electronic module according to an eighth embodiment.

An optical element mounting package 101G and an electronic device 100G of the eighth embodiment are different from those of the third embodiment mainly in form of a protrusion 120G. The components same as those of the third embodiment are denoted by the same reference signs as those in the third embodiment, and detailed descriptions thereof are omitted.

The optical element mounting package 101G includes: the base 110B having the recess 111, the sealing portion 116A and the protrusion 120G; and the wiring conductors 130Ca, 130Cb. The protrusion 120G protrudes leftward from the left side wall portion 112b. At a connection portion between the protrusion 120G and the left side wall portion 112b, a level difference D2 is provided. The level difference D2 is present on the upper surface 110a of the base 110B, and the upper surface of the protrusion 120G is higher than the upper surface of the other portion, which is not the protrusion 120G. There may be a similar level difference(s) between the front surface of the protrusion 120G and the front surface of the other portion, which is not the protrusion 120G, of the base 110B and/or between the back surface of the protrusion 120G and the back surface of the other portion, which is not the protrusion 120G, of the base 110B.

The wiring conductors 130Ca, 130Cb are disposed on the upper surface of the protrusion 120G, the upper surface being higher by the level difference D2.

The electronic device 100G includes the optical element mounting package 101G, the optical element 102, the optical component 103, the lid 105 and the submount 106.

According to the optical element mounting package 101G and the electronic device 100G of the eighth embodiment, in addition to the effects of the third embodiment, if the electronic device 100G is to be mounted on the module surface 210, a space between the substrate surface and the electronic device 100G can be widened by utilizing the level difference D2. This can, for example, prevent the lid 105 from contacting the substrate surface and enhance mounting reliability of the electronic device 100G.

### (Electronic Module)

### <First Example>

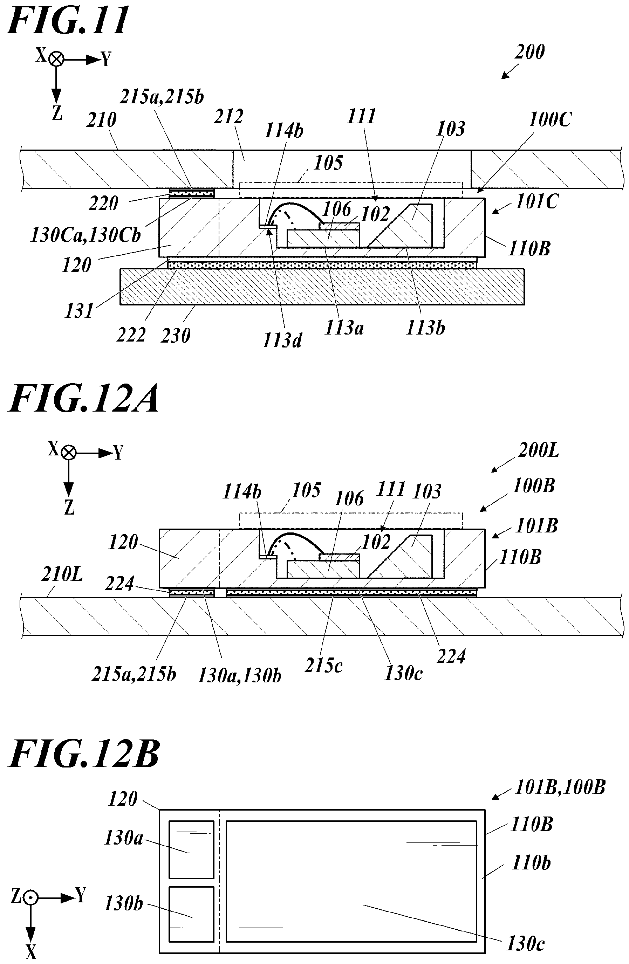

FIG. 11 is a vertical sectional view showing a first example of an electronic module according to an embodiment.

An electronic module 200 shown in FIG. 11 includes the electronic device 100C of the fourth embodiment and the module substrate 210. On the module substrate 210, an electronic device(s) other than the electronic device 100C, an electronic element(s), an electric element(s) and/or the like may be mounted.

The electronic device 100C is to be mounted on the module substrate 210 such that its upper surface faces the plate surface of the module substrate 210. The module substrate 210 has a through hole 212 for outputting light, and the upper surface of the lid 105 is located in the through hole 212. The wiring conductors 130Ca, 130Cb are joined to connecting pads 215a, 215b of the module substrate 210 with a joining material 220, such as solder.

The electronic device 100C shown in FIG. 11 further includes a dummy wiring conductor 131 on the lower surface. The electronic module 200 further includes a heat sink 230 connected to the wiring conductor 131 with a joining material 222, such as solder.

In the electronic module 200 of the first example, the electronic device 100C is replaceable by any of the electronic devices 100D to 100G of the fifth to seventh embodiments, in each of which the non-dummy wiring conductors 130Ca, 130Cb are disposed on the upper surface of the protrusion 120D, 120E, 120F or 120G.

If the electronic device 100D or 100E of the fifth or sixth embodiment is applied, since the lower portion(s) is composed of a metal, the heat sink 230 may be joined, with the joining material 222, to the lower surface(s) of the base 110D or 110E and the protrusion 120D or 120E included in the base 110D or 110E, without the dummy wiring conductor 131 on the lower surface.

If the electronic device 100F of the seventh embodiment is applied, as shown in FIG. 9, in the through hole 212 of the module substrate 210, the lid 105 and the upper end portion of the base 110B are located. This configuration shows an effect of easily positioning the electronic device 100F if mounting it, by inserting the upper portion of the electronic device 100F into the through hole 212.

If the electronic device 100G of the eighth embodiment is applied, as shown in FIG. 10, the electronic device 100G is mounted to be at a height (level) at which the lid 105 does not enter the through hole 212 of the module substrate 210. This configuration can prevent the lid 105 from contacting the module substrate 210 and enhance the mounting reliability. Further, the through hole 212 can be made smaller than the lid 105.

### <Second Example>

FIG. 12A and FIG. 12B show a second example of the electronic module according to this embodiment. FIG. 12A is a vertical sectional view, and FIG. 12B is a bottom view of an optical element mounting package.

An electronic module 200L shown in FIG. 12A includes the electronic device 100B of the third embodiment and a module substrate 210L.

The electronic device 100B is mounted on the module substrate 210L such that its lower surface faces the plate surface of the module substrate 210L. The wiring conductors 130a, 130b of the electronic device 100B are joined to the connecting pads 215a, 215b of the module substrate 210L with a joining material 224, such as solder.

As shown in FIG. 12B, the electronic device 100B may further include a dummy wiring conductor 130c on the lower surface. The dummy wiring conductor 130c may be joined to a connecting pad 215c as the ground or the like of the module substrate 210L with the joining material 224, such as solder.

In the electronic module 200L of the second example, the electronic device 100B is replaceable by either of the electronic devices 100 and 100A of the first and second embodiments, each of which has the wiring conductors 130a, 130b on the lower surface. In the electronic devices 100C, 100F, 100G of the fourth, seventh and eighth embodiments, if the wiring conductors 130Ca, 130Cb on the upper surface of the protrusion 120, 120F or 120G are dummies or the like, and the wiring conductors 130a, 130b electrically connected to the optical element 102 are on the lower surface, they can be applied instead of the electronic device 100B.

### <Third Example>

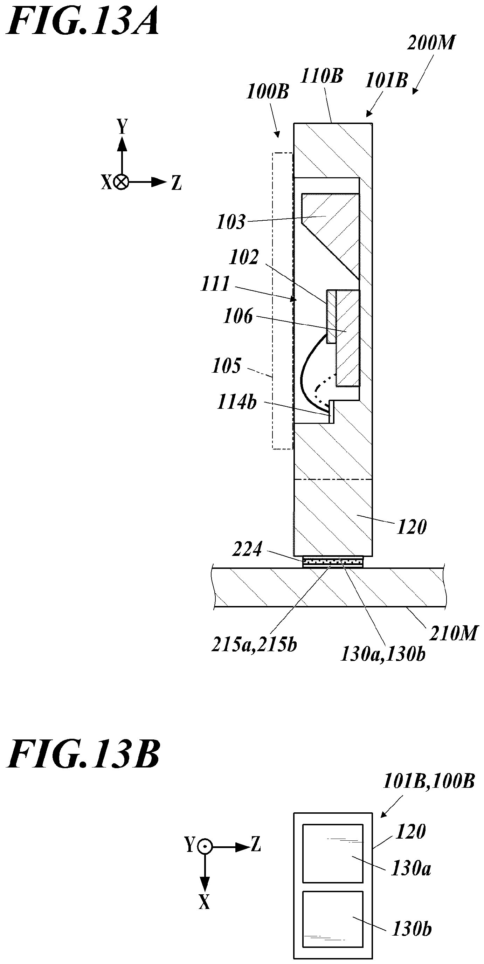

FIG. 13A and FIG. 13B show a third example of the electronic module according to this embodiment. FIG 13A is a vertical sectional view, and FIG 13B is a left side view of an optical element mounting package.

An electronic module 200M shown in FIG. 13A includes the electronic device 100B of the third embodiment and a module substrate 210M. However, in the electronic device 100B shown in FIG. 13B, the wiring conductors 130a, 130b electrically connected to the optical element 102 are disposed on the left end surface of the protrusion 120.

The electronic device 100B is mounted on the module substrate 210M such that the left end surface of the protrusion 120 faces the plate surface of the module substrate 210M. The wiring conductors 130a, 130b of the electronic device 100B are joined to the connecting pads 215a, 215b of the module substrate 210M with the joining material 224, such as solder.

In the electronic modules 200M of the third example, the electronic device 100B is replaceable by any of the electronic devices 100, 100A, and 100C to 100G of the first, second, and fourth to eighth embodiments. However, even in the electronic devices 100, 100A, and 100C to 100G of the first, second, and forth to eighth embodiments, those having the configuration in which the wiring conductors 130a, 130b electrically connected to the optical element 102 are disposed on the left end surface are only applicable.

According to the electronic modules 200, 200L, 200M described above, an optical module having stable optical characteristics can be provided.

### <First Manufacturing Method of Optical Element Mounting Package>

Hereinafter, a manufacturing method of the optical element mounting package 101 of the first embodiment will be described. The same manufacturing method is applicable for the optical element mounting packages 101A to 101C, 101F and 101G of the second to fourth, seventh and eighth embodiments.

For the base 110 including the protrusion 120, for example, ceramic, such as an aluminum oxide sintered body (alumina ceramic), an aluminum nitride sintered body, a mullite sintered body or a glass-ceramic sintered body, is usable. If the base 110 is composed of an aluminum oxide sintered body having aluminum oxide (Al₂O₃) as a main component, powder of silica (SiO₂), magnesia (MgO), calcia (CaO) or the like is added as a sintering aid to powder of Al₂O₃, and also proper binder, solvent and plastic are added thereto. Next, a mixture of these is kneaded into slurry. Thereafter, multi-cavity ceramic green sheets are obtained by a molding method, such as the well-known doctor blade method.

Using the ceramic green sheets, the optical element mounting package(s) 101 is manufactured by the following steps [1] to [5].

The step [1] is a step of punching portions serving as the recesses 111 by using a punching die. The upper surfaces 110a of the bases 110, the upper surfaces 110a each including the sealing portion 116, may be formed by pressing a jig or the like against a ceramic green sheet(s).

The step [2] is a step of printing/applying conductive paste for forming the electrodes 114a, 114b and the wiring conductors 130a, 130b on the bases 110.

The step [3] is a step of stacking ceramic green sheets serving as insulating layers thereon, thereby manufacturing a ceramic green sheet laminate, or without the step [1], a step of applying pressure to ceramic green sheets by using a die for making the shape of the base 110 having the recess 111 and the protrusion 120, thereby manufacturing a molded body.

The step [4] is a step of firing the ceramic green sheet laminate at a temperature of about 1,500 to 1,800°C, thereby producing a multi-cavity substrate in which the bases 110 each including the electrodes 114a, 114b and the wiring conductors 130a, 130b are arranged.

The step [5] is a step of dividing the multi-cavity substrate, which has been produced by the firing, by splitting it along dividing grooves formed at portions serving as the outer edges of optical element mounting packages 101, or cutting the multi-cavity substrate along portions serving as the outer edges of optical element mounting packages 101 by a slicing method or the like.

The dividing grooves can be formed by, after the firing, making cuts smaller (shallower) than the thickness of the multi-cavity substrate with a slicing device, but may be formed by pressing a cutter blade onto the ceramic green sheet laminate for the multi-cavity substrate or by making cuts smaller (shallower) than the thickness of the ceramic green sheet laminate with a slicing device.

In the step [2] described above, the wiring conductors 130a, 130b are formed at predetermined points on each of the bases 110 by printing the conductive paste on the ceramic green sheet(s) for the bases 110 in predetermined shapes by a screen printing method or the like and firing the conductive paste together with the ceramic green sheet(s) for the bases 110. As to the internal wirings that pass through the ceramic green sheet(s) in the thickness direction, through holes formed in the ceramic green sheet(s) are filled with the conductive paste being printed. Such conductive paste having an appropriately adjusted viscosity is prepared by adding proper solvent and binder to metal powder, such as powder of tungsten, molybdenum, manganese, silver or copper, and mixing/kneading these. The conductive paste may contain glass and/or ceramic in order to enhance the joining strength to the bases 110.

The exposed surfaces of the electrodes 114a, 114b and the wiring conductors 130a, 130b may be coated with a nickel plating layer having a thickness of 0.5 to 5 µm and a gold plating layer having a thickness of 0.1 to 3 µm in order, or may be coated with a nickel plating layer having a thickness of 1 to 10 µm and a silver plating layer having a thickness of 0.1 to 1 µm in order. This can efficiently suppress corrosion of the electrodes 114a, 114b and the wiring conductors 130a, 130b, and also can firmly join the electrodes 114a, 114b to the connecting members W1, W2 and firmly join the wiring conductors 130a, 130b to the connecting pads 215a, 215b of the module substrate 210.

### <Second Manufacturing Method of Optical Element Mounting Package>

Next, a manufacturing method of the optical element mounting package 101D or 101E of the fifth or sixth embodiment will be described. This manufacturing method is different from the above manufacturing method in terms of that the base 110D or 110E including the protrusion 120D or 120E includes the metal portions 110Da, 120Da or 110Ea, 120Ea.

The insulating portions 110Db, 120Db or 110Eb, 120Eb of the base 110D or 110E are manufactured by the same method as the above-described first manufacturing method.

The metal portions 110Da, 120Da or 110Ea, 120Ea of the base 110D or 110E are manufactured by a well-known technology, such as press-forming, from copper or aluminum as a high heat radiating material or an alloy containing any of these as a main component.

Thereafter, the insulating portions 110Db, 120Db or 110Eb, 120Eb are joined to the metal portions 110Da, 120Da or 110Ea, 120Ea by brazing or the like, so that the optical element mounting package 101D or 101E is manufactured.

### (Ninth Embodiment)

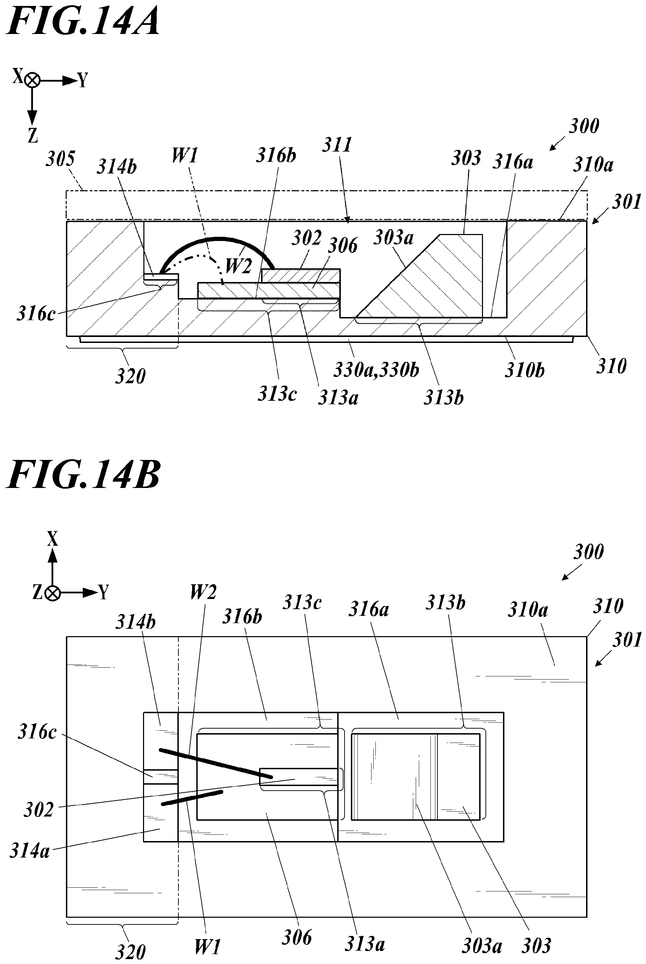

FIG. 14A and FIG. 14A show an optical element mounting package and an electronic device according to a ninth embodiment. FIG. 14A is a vertical sectional view, and FIG. 14B is a plan view. Hereinafter, directions of an optical element mounting package 301 may be expressed by using directions of three orthogonal axes X, Y, Z shown in the drawings. The Z direction corresponds to the depth direction of a recess 311 provided in the optical element mounting package 301. Up and down, high and low, front and back, and right and left may be expressed by regarding the Z direction as the downward direction, the reversed Z direction as the upward direction, directions along the X axis as the front and back directions, and directions along the Y axis as the right and left directions. The front, back, right, left, up and down referred to in this description/specification may be different from those if an electronic device is installed in an electronic module.

### <Optical Element Mounting Package>

The optical element mounting package 301 of the ninth embodiment is a surface-mount package, and includes: a base 310 having the recess 311; and wiring conductors 330a, 330b disposed on the outer surface of the base 310.

The base 310 has a first main surface 310a on the upper side, a second main surface 310b on the opposite side, and the recess 311 that is open in the first main surface 310a. All or part of the first main surface 310a functions as a sealing surface to which a lid 305 is joined. The base 310 is an insulator, such as ceramic, and may have, inside, a conductor that electrically connects electrodes 314a, 314b in the recess 311 to the wiring conductors 330a, 330b on the outer surface.

The recess 311 is surrounded by the inner surface of a side wall and the inner bottom surface, and is open in its upper side. The inner bottom surface of the recess 311 includes a first inner bottom surface 316a, a first step portion 316b higher than the first inner bottom surface 316a, and a second step portion 316c higher than the first step portion 316b. The first inner bottom surface 316a, the first step portion 316b and the second step portion 316c are arranged in this order in the Y axis direction. That is, the second step portion 316c is located opposite the first inner bottom surface 316a with the first step portion 316b in between. In a vertical section (e.g. a section along the Y-Z plane) intersecting the opening of the recess 311, the first inner bottom surface 316a, the first step portion 316b and the second step portion 316c, the second step portion 316c is connected to (or is continuous with) the inner side surface of the recess 311.

The recess 311 further includes a first mounting portion 313a where an optical element (e.g. laser diode) 302 is to be mounted, a second mounting portion 313b where an optical component (e.g. mirror) 303 is to be mounted, a third mounting portion 313c where a submount 306 is to be mounted, and the electrodes 314a, 314b to be electrically connected to the optical element 302.

In the base 310, a portion leftward from the second step portion 316c and including itself (a portion leftward from a chain line in FIG. 14A and FIG. 14B) is a heat radiating portion 320. The heat radiating portion 320 can efficiently guide heat of the first mounting portion 313a to the outside of the base 310, so that heat to be conducted from the first mounting portion 313a to the second mounting portion 313b is reduced.

The second mounting portion 313b is located on the first inner bottom surface 316a. The first mounting portion 313a and the third mounting portion 313c are located on the first step portion 316b. The third mounting portion 313c includes the first mounting portion 313a, and has a spread to near the second step portion 316c as compared with the first mounting portion 313a. The submount 306 is interposed between the optical element 302 and the first mounting portion 313a, and the optical element 302 is mounted on the first mounting portion 313a via the submount 306. The optical element 302 may be directly mounted on the first mounting portion 313a. The first mounting portion 313a corresponds to a region produced by projecting the optical element 302 on the inner bottom surface of the recess 311 along the Z direction. The electrodes 314a, 314b are arranged on and fixed to the second step portion 316c.

The wiring conductors 330a, 330b are planar or plate-like conductors, and although not particularly limited, in this embodiment, disposed on the second main surface 310b of the base 310. The wiring conductors 330a, 330b are electrically connected to the electrodes 314a, 314b in the recess 311 via conductor(s) passing inside the base 310. In the example shown in FIG. 14A, the two wiring conductors 330a, 330b are arranged on the front (near) side and the back (far) side of the paper surface.

### <Electronic Device>

The electronic device 300 of the ninth embodiment includes, as shown in FIG. 14, the optical element mounting package 301, the optical element 302, the optical component 303, the lid 305 and the submount 306.

The optical element 302 is a laser diode or the like, and may have, for example, a property of generating heat if electrically driven. The optical element 302 is to be mounted on the first mounting portion 313a of the base 310 via the submount 306. The optical element 302 is mounted such that its laser light emitting portion faces rightward, and emits laser light to the optical component 303. Two electrodes of the optical element 302 are electrically connected to the electrodes 314a, 314b via the connecting members W1, W2, such as bonding wires. One (connecting member W1 in FIG. 14) or both of the connecting members W1, W2 may be electrically connected to one of the electrodes of the optical element 302 via an electrical wiring disposed on the submount 306.

The submount 306 is a stand interposed between the optical element 302 and the first mounting portion 313a, and mounted on the third mounting portion 313c. The submount 306 may be omitted. The submount 306 brings about an effect of diffusing heat generated in the optical element 302, an effect of raising the optical axis of the optical element 302, and an effect of relieving stress applied to the optical element 302 due to thermal expansion difference between the optical element 302 and the base 310. The submount 306 may have an electrical wiring that is electrically connected to an electrode (e.g. ground electrode) of the optical element 302.

The optical component 303 is, for example, a mirror, and to be mounted on the second mounting portion 313b of the base 310, and has a reflection surface 303a inclined with respect to the first main surface 310a of the base 310. The optical component 303 reflects the laser light, which the optical element 302 has emitted rightward, upward with the reflection surface 303a. The optical component 303 is configured, for example, by forming a reflective film on, for example, glass, resin or a metal plate. The optical component 303 may have a property that characteristics are changed by heat.

The lid 305 is a plate-like translucent member, and its peripheral portion is joined to the first main surface 310a of the base 310 with a joining material. The lid 305 is joined over the entire periphery of the opening of the recess 311, so that the recess 311 is sealed (covered) therewith.

### <Description of Operation>

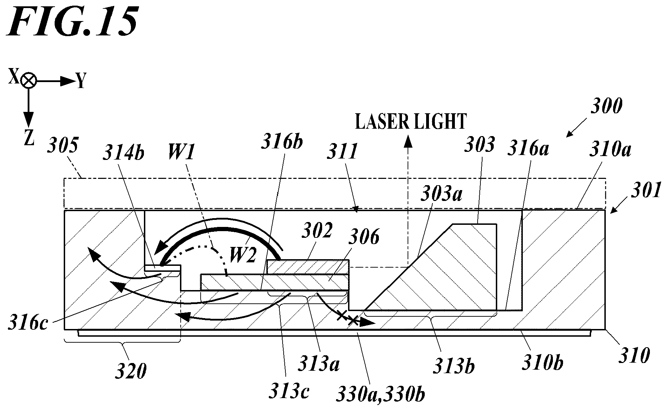

FIG. 15 is a diagram for explaining heat radiation of the optical element mounting package and the electronic device according to the ninth embodiment. In FIG. 15, flow of heat is indicated by solid arrows.

If the electronic device 300 is driven, a voltage is input to the optical element 302 via the wiring conductors 330a, 330b of the electronic device 300, so that the optical element 302 is driven. If the optical element 302 is driven, laser light is emitted from the optical element, and the emitted laser light is reflected by the optical component 303 and passes through the lid 305, thereby exiting to the outside of the electronic device 300.

If the optical element 302 is driven, the optical element 302 generates heat. Part of the heat passes through the submount 306 and diffuses from the third mounting portion 313c (diffuses directly from the first mounting portion 313a if the submount 306 is not provided) to the first step portion 316b, and part of the heat diffuses to the second step portion 316c of the base 310 via the connecting members W1, W2 and the electrodes 314a, 314b.

At the bottom of the base 310, the portions under the first mounting portion 313a, the third mounting portion 313c and the electrodes 314a, 314b have a larger heat capacity than the portion under the second mounting portion 313b by the thicknesses of the first step portion 316b and the second step portion 316c. Hence, much of the heat diffused to the first step portion 316b and the second step portion 316c diffuses leftward as indicated by arrows in FIG. 15. That is, as compared with the case where the first step portion 316b and the second step portion 316c are not provided, diffusion and conduction of heat rightward to the optical component 303 via the second mounting portion 313b is reduced.

### <Effects of Embodiment>

As described above, according to the optical element mounting package 301 and the electronic device 300 of the ninth embodiment, the base 310 having the recess 311 is provided, and the recess 311 includes the first mounting portion 313a where the optical element 302 is to be mounted and the second mounting portion 313b where the optical component 303 is to be mounted. This configuration yields the surface-mount optical element mounting package 301 and electronic device 300. According to the surface-mount optical element mounting package 301 and electronic device 300, since their outer surfaces are joined to a module substrate surface-to-surface, even if they are small, high heat radiation performance is obtained.

Further, according to the optical element mounting package 301 and the electronic device 300 of the ninth embodiment, the recess 311 has the first inner bottom surface 316a (where the second mounting portion 313b is located) where the optical component 303 is to be mounted. In addition, the recess 311 includes: the first step portion 316b that is higher than the first inner bottom surface 316a and (where the first mounting portion 313a is located) where the optical element 302 is to be mounted; and the second step portion 316c 314b that is higher than the first step portion 316b and where the electrodes 314a, 314b are arranged. In a vertical section as shown in FIG. 14A, the second step portion 316c is located opposite the first inner bottom surface 316a with the first step portion 316b in between, and also connected to the inner side surface of the recess 311. This configuration, as described above, can reduce conduction of heat generated in the optical element 302 to the optical component 303. Hence, even if the amount of heat generated in the optical element 302 increases, it is possible to suppress deterioration, such as deformation, of the optical component 303 due to the heat from the optical element 302, and accordingly can obtain stable optical characteristics of the optical component 303. Thus, it is possible to maintain optical characteristics stably.

### (Tenth Embodiment)

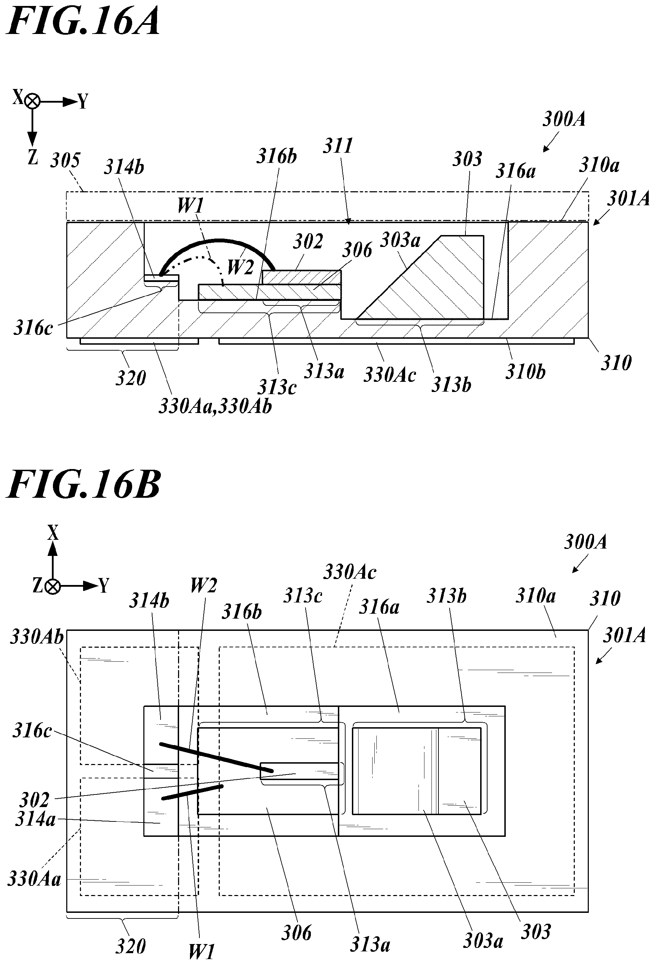

FIG. 16A and FIG. 16A show an optical element mounting package and an electronic device according to a tenth embodiment. FIG. 16A is a vertical sectional view, and FIG. 16B is a plan view. An optical element mounting package 301A of the tenth embodiment is a surface-mount package, and includes: the base 310 having the recess 311; and wiring conductors 330Aa, 330Ab and a mounting conductor 330Ac disposed on the outer surface of the base 310. An electronic device 300A of the tenth embodiment includes the optical element mounting package 301A, the optical element 302 and the optical component 303 mounted thereon, and the lid 305 with which the recess 311 is sealed.

The tenth embodiment is different from the ninth embodiment mainly in configurations of the wiring conductors 330Aa, 330Ab and the mounting conductor 330Ac. The components same as those of the ninth embodiment are denoted by the same reference signs as those in the ninth embodiment, and detailed descriptions thereof are omitted.

The wiring conductors 330Aa, 330Ab and the mounting conductor 330Ac are planar or plate-like conductors, and disposed on the second main surface 310b of the base 310. The wiring conductors 330Aa, 330Ab are electrically connected to the electrodes 314a, 314b in the recess 311. The mounting conductor 330Ac is joined to a connecting pad as the ground or the like of a module substrate if the electronic device 300A is mounted on the module substrate in order to enhance the joining strength and joining stability of the electronic device 300A thereto. The mounting conductor 330Ac may be referred to as a dummy wiring conductor. The mounting conductor 330Ac may not be electrically connected to either of the electrodes 314a, 314b, or may be electrically connected to a ground electrode between the electrodes 314a, 314b.

The two wiring conductors 330Aa, 330Ab are arranged in the X direction, and the width of these two wiring conductors 330Aa, 330Ab in the X direction as a whole is larger than the width of the recess 311, but is not limited thereto and hence may be smaller than the width of the recess 311. The mounting conductor 330Ac has a width in the X direction larger than the recess 311 has, but is not limited thereto and hence may have a width smaller than the recess 311 has.

### <Arrangement of Wiring Conductors and Mounting Conductor>

As shown in FIG. 16B, in a perspective plane viewed in the Z direction, the wiring conductors 330Aa, 330Ab lie on part (or all) of the second step portion 316c and lie on part (or all) of the electrodes 314a, 314b.

The mounting conductor 330Ac is separate from the wiring conductors 330Aa, 330Ab, and arranged on the right side of the wiring conductors 330Aa, 330Ab. As shown in FIG. 16B, in the perspective plane viewed in the Z direction, the mounting conductor 330Ac lies on all (or part) of the first inner bottom surface 316a and the second mounting portion 313b and lies on part (or all) of the first step portion 316b, the first mounting portion 313a and the third mounting portion 313c.

### <Effects of Embodiment>

As described above, according to the optical element mounting package 301A and the electronic device 300A of the tenth embodiment, the configuration same as that of the ninth embodiment can reduce conduction of heat generated in the optical element 302 to the optical component 303. This can suppress deterioration of the optical characteristics due to the influence of heat from the optical element 302.

Further, in the tenth embodiment, in the perspective plane viewed in the Z direction, the wiring conductors 330Aa, 330Ab lie on the second step portion 316c and the electrodes 314a, 314b. Hence, a heat conduction path from the electrodes 314a, 314b to the wiring conductors 330Aa, 330Ab is short. The heat conducted from the optical element 302 to the second step portion 316c via the connecting members W1, W2 diffuses at the bottom of the base 310. However, since the path to the wiring conductors 330Aa, 330Ab is short, much of the diffused heat can be conducted to the wiring conductors 330Aa, 330Ab and released to the outside of the package. This can further reduce conduction of heat generated in the optical element 302 to the optical component 303, and further suppress deterioration of the optical characteristics due to the influence of heat generated in the optical element 302.

Further, in the tenth embodiment, in the perspective plane viewed in the Z direction, the mounting conductor 330Ac lies on the first inner bottom surface 316a and the second mounting portion 313b. Hence, part of the heat conducted from the optical element 302 to the bottom of the base 310 and diffused to the underneath of the first inner bottom surface 316a is released to the outside of the package via the mounting conductor 330Ac. This can further reduce heat that is conducted to the optical component 303, and further suppress deterioration of the optical characteristics due to the influence of heat generated in the optical element 302.

### <Modification>

Positions (arrangement) of the wiring conductors 330Aa, 330Ab and the mounting conductor 330Ac are not limited to the specific example shown in FIG. 16B. For example, in the perspective plane viewed in the Z direction, the wiring conductors 330Aa, 330Ab may or may not lie on part of the first step portion 316b, the first mounting portion 313a, the third mounting portion 313c, the first inner bottom surface 316a and the second mounting portion 313b. Even such arrangement brings about the same effects as those of the above-described tenth embodiment.

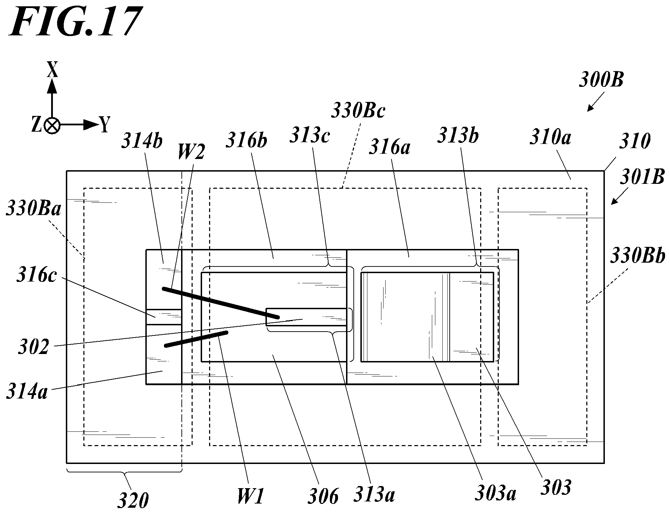

FIG. 17 is a plan view showing an optical element mounting package and an electronic device according to a modification of the tenth embodiment. The wiring conductors 330Aa, 330Ab and the mounting conductor 330Ac shown in FIG. 16B may be replaced by wiring conductors 330Ba, 330Bb and a mounting conductor 330Bc shown in FIG. 17.

An optical element mounting package 301B and an electronic device 300B shown in FIG. 17 are an example in which the two wiring conductors 330Ba, 330Bb are arranged in the Y direction. In this arrangement, in the perspective plane viewed in the Z direction, one of the wiring conductors, 330Ba, lies on all (or part) of the second step portion 316c and all (or part) of the electrodes 314a, 314b. Each of the wiring conductors 330Ba, 330Bb has a width in the X direction larger than the recess 311 has, but is not limited thereto and hence may have a width smaller than the recess 311 has. The mounting conductor 330Bc is disposed between the two wiring conductors 330Ba, 330Bb. In the perspective plane viewed in the X direction, the mounting conductor 330Bc lies on part (or all) of the first inner bottom surface 316a and the second mounting portion 313b. In the same perspective plane, the mounting conductor 330Bc lies on part (or all) of the first step portion 316b, the first mounting portion 313a and the third mounting portion 313c. The configuration shown in FIG. 17 also brings about the same effects as those of the above-described tenth embodiment.

Further, in the configuration shown in FIG. 17 too, in the perspective plane viewed in the Z direction, one of the wiring conductors, 330Ba, may or may not lie on part of the first step portion 316b, the first mounting portion 313a, the third mounting portion 313c, the first inner bottom surface 316a and the second mounting portion 313b. In the same perspective plane, the other of the wiring conductors, 330Bb, may or may not lie on part of the first step portion 316b, the first mounting portion 313a, the third mounting portion 313c, the first inner bottom surface 316a and the second mounting portion 313b. In the same perspective plane, the mounting conductor 330Bc may not lie on the first step portion 316b, the first mounting portion 313a and the third mounting portion 313c. Such arrangement also brings about the same effects as those of the above-described tenth embodiment.

### (Eleventh Embodiment)

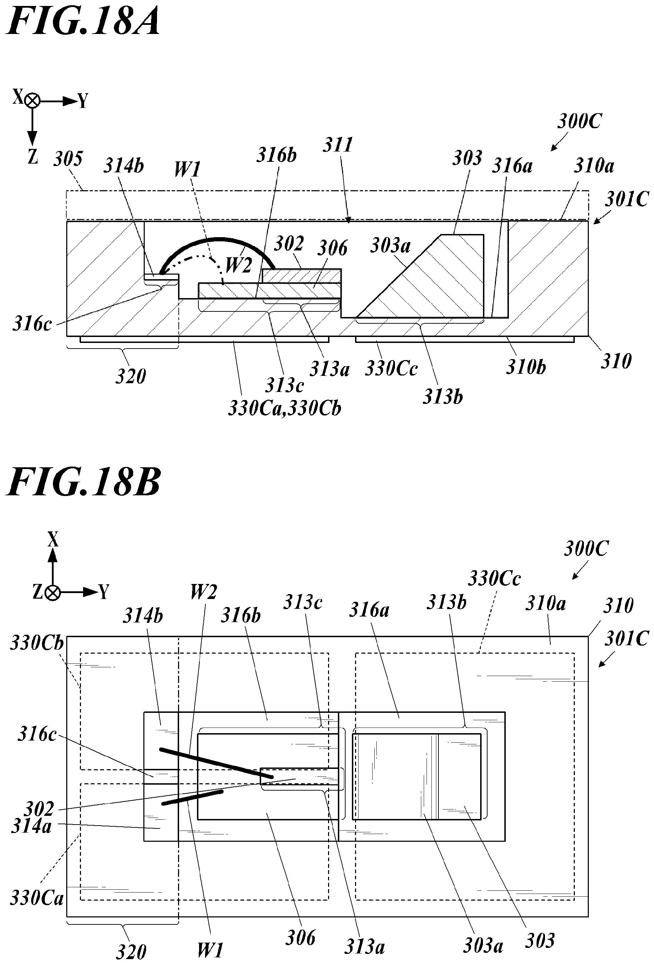

FIG. 18A and FIG. 18A show an optical element mounting package and an electronic device according to an eleventh embodiment. FIG. 18A is a vertical sectional view, and FIG. 18B is a plan view. An optical element mounting package 301C of the eleventh embodiment is a surface-mount package, and includes: the base 310 having the recess 311; and wiring conductors 330Ca, 330Cb and a mounting conductor 330Cc disposed on the second main surface 310b of the base 310. An electronic device 300C of the eleventh embodiment includes the optical element mounting package 301C, the optical element 302 and the optical component 303 mounted thereon, and the lid 305 with which the recess 311 is sealed.

The eleventh embodiment is different from the tenth embodiment mainly in arrangement of the wiring conductors 330Ca, 330Cb and the mounting conductor 330Cc. The components same as those of the tenth embodiment are denoted by the same reference signs as those in the tenth embodiment, and detailed descriptions thereof are omitted. The wiring conductors 330Ca, 330Cb and the mounting conductor 330Cc are the same as the wiring conductors 330Aa, 330Ab and the mounting conductor 330Ac of the tenth embodiment except for arrangement (positions) thereof in the Y direction.

### <Arrangement of Wiring Conductors and Mounting Conductor>

As shown in FIG. 18B, in the perspective plane viewed in the Z direction, the wiring conductors 330Ca, 330Cb lie on part (or all) of the first step portion 316b and part (or all) of the third mounting portion 313c. In the same perspective plane, the wiring conductors 330Ca, 330Cb lie on part (or all) of the second step portion 316c and part (or all) of the electrodes 314a, 314b.

As shown in FIG. 18B, in the perspective plane viewed in the Z direction, the mounting conductor 330Cc lies on part (or all) of the first inner bottom surface 316a and part (or all) of the second mounting portion 313b.

### <Effects of Embodiment>

As described above, according to the optical element mounting package 301C and the electronic device 300C of the eleventh embodiment, the configuration same as that of the ninth embodiment can reduce conduction of heat generated in the optical element 302 to the optical component 303, and hence can suppress deterioration of the optical characteristics due to the influence of heat.

Further, in the eleventh embodiment, in the perspective plane viewed in the Z direction, the wiring conductors 330Ca, 330Cb lie on the first step portion 316b and the third mounting portion 313c. Hence, a path from the third mounting portion 313c to the wiring conductors 330Ca, 330Cb is short. The heat conducted from the optical element 302 to the first step portion 316b via the submount 306 diffuses at the bottom of the base 310. However, since the path to the wiring conductors 330Ca, 330Cb is short, much of the diffused heat can be conducted to the wiring conductors 330Ca, 330Cb and released to the outside of the package. This can further reduce conduction of heat generated in the optical element 302 to the optical component 303, and further suppress deterioration of the optical characteristics due to the influence of heat generated in the optical element 302.

Further, in the eleventh embodiment, in the perspective plane viewed in the Z direction, the mounting conductor 330Cc lies on the first inner bottom surface 316a and the second mounting portion 313b. Hence, part of the heat conducted from the optical element 302 to the bottom of the base 310 and diffused to the underneath of the first inner bottom surface 316a is released to the outside of the package via the mounting conductor 330Cc. This can further reduce heat that is conducted to the optical component 303, and further suppress deterioration of the optical characteristics due to the influence of heat generated in the optical element 302.

### <Modification>

Positions (arrangement) of the wiring conductors 330Ca, 330Cb and the mounting conductor 330Cc are not limited to the specific example shown in FIG. 18B. For example, in the perspective plane viewed in the Z direction, the wiring conductors 330Ca, 330Cb may not lie on the second step portion 316c and the electrodes 314a, 314b. In the same perspective plane, the wiring conductors 330Ca, 330Cb may or may not lie on part of the first inner bottom surface 316a and the second mounting portion 313b. The mounting conductor 330Cc may lie on part of the first step portion 316b, the first mounting portion 313a and the third mounting portion 313c. Even such arrangement brings about the same effects as those of the above-described eleventh embodiment.

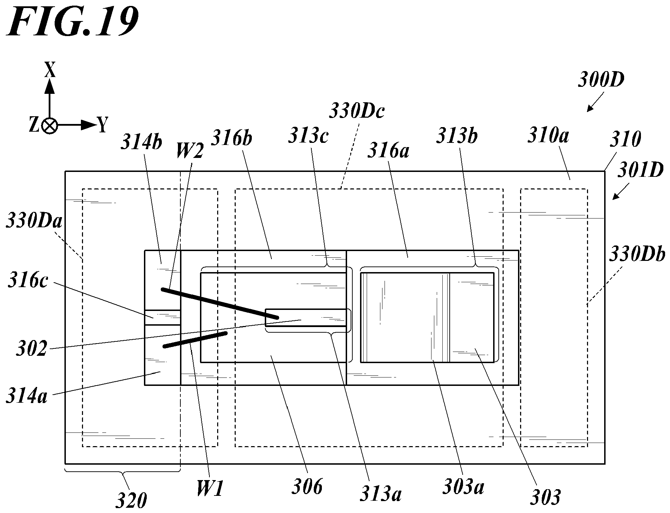

FIG. 19 is a plan view showing an optical element mounting package and an electronic device according to a modification of the eleventh embodiment. The wiring conductors 330Ca, 330Cb and the mounting conductor 330Cc shown in FIG. 18B may be replaced by wiring conductors 330Da, 330Db and a mounting conductor 330Dc shown in FIG. 19.

An optical element mounting package 301D and an electronic device 300D shown in FIG. 19 are an example in which the two wiring conductors 330Da, 330Db are arranged in the Y direction. In this arrangement, in the perspective plane viewed in the Z direction, one of the wiring conductors, 330Da, lies on part (or all) of the first step portion 316b and the third mounting portion 313c. In the same perspective plane, the wiring conductor 330Da lies on all (or part) of the second step portion 316c and all (or part) of the electrodes 314a, 314b. The mounting conductor 330Dc is disposed between the two wiring conductors 330Da, 330Db. In the perspective plane viewed in the Z direction, the mounting conductor 330Dc lies on part (or all) of the first inner bottom surface 316a and all (or part) of the second mounting portion 313b. The configuration shown in FIG. 19 also brings about the same effects as those of the above-described eleventh embodiment.

Further, in the configuration shown in FIG. 19 too, in the perspective plane viewed in the Z direction, the wiring conductors 330Da, 330Db may not lie on the second step portion 316c and the electrodes 314a, 314b. The mounting conductor 330Dc may not lie on the first step portion 316b, the first mounting portion 313a and the third mounting portion 313c. Even such arrangement brings about the same effects as those of the above-described eleventh embodiment.

### (Twelfth Embodiment)

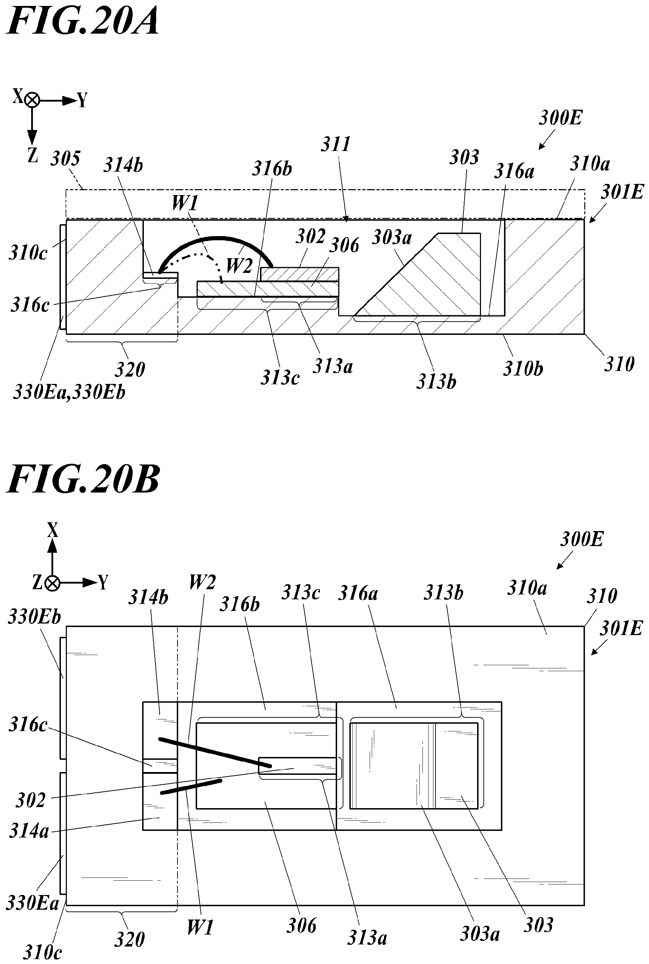

FIG. 20A and FIG. 20A show an optical element mounting element and an electronic device according to a twelfth embodiment. FIG. 20A is a vertical sectional view, and FIG. 20B is a plan view. An optical element mounting element package 301E of the twelfth embodiment is a surface-mount package, and includes: the base 310 having the recess 311; and wiring conductors 330Ea, 330Eb disposed on a side surface 310c of the base 310. An electronic device 300E of the eleventh embodiment includes the optical element mounting package 301E, the optical element 302 and the optical component 303 mounted thereon, and the lid 305 with which the recess 311 is sealed. The components of the twelfth embodiment same as those of the tenth and/or eleventh embodiment(s) are denoted by the same reference signs as those in the tenth and/or eleventh embodiment(s), and detailed descriptions thereof are omitted.

The twelfth embodiment is different from the tenth and eleventh embodiments mainly in that the wiring conductors 330Ea, 330Eb are disposed on the side surface 310c of the base 310. The wiring conductors 330Ea, 330Eb are planar or plate-like conductors. The side surface 310c corresponds to an example of a first outer side surface according to the present invention. The side surface 310c is located opposite the first step portion 316b with the second step portion 316c in between. In the electronic device 300E of the twelfth embodiment too, a mounting conductor may be provided on the second main surface 310b. The wiring conductors on the side surface 310c may be mounting conductors, and wiring conductors or these and a mounting conductor may be provided on the second main surface 310b. The mounting conductor may be joined to a heat sink.

According to the optical element mounting package 301E and the electronic device 300E of the twelfth embodiment, heat generated in the optical element 302 and diffused leftward via the first step portion 316b and the second step portion 316c can be efficiently released to the outside of the package from the wiring conductors 330Ea, 330Eb on the side surface 310c. This can further reduce heat that is conducted from the optical element 302 to the optical component 303, and further suppress deterioration of the optical characteristics due to the influence of heat generated in the optical element 302.

### (Electronic Module)

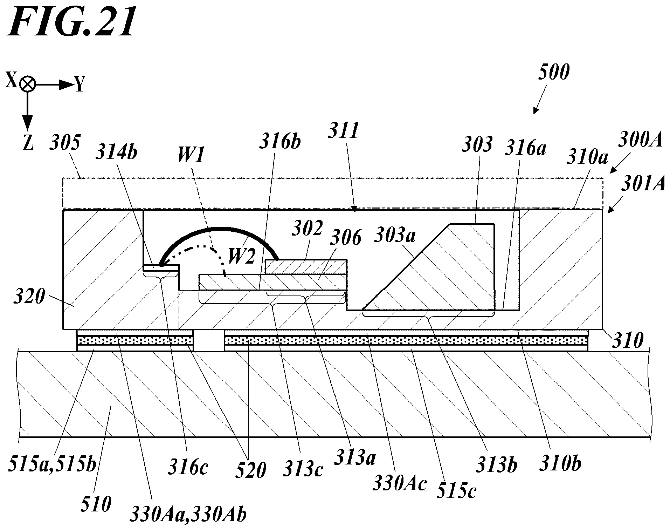

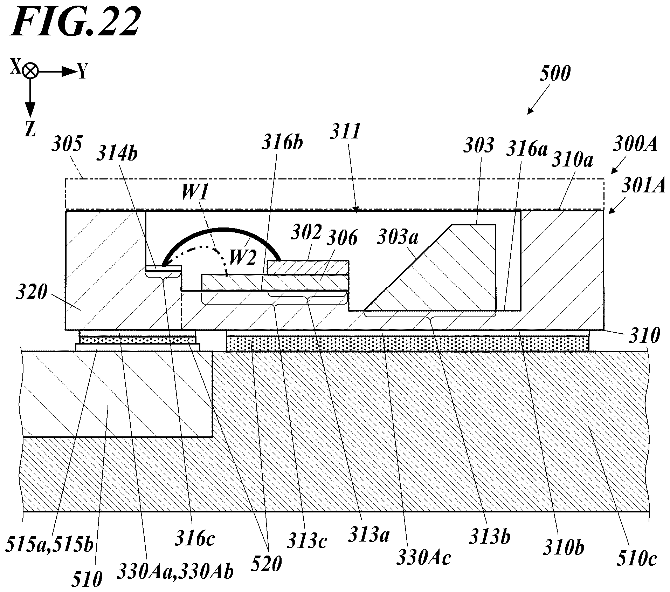

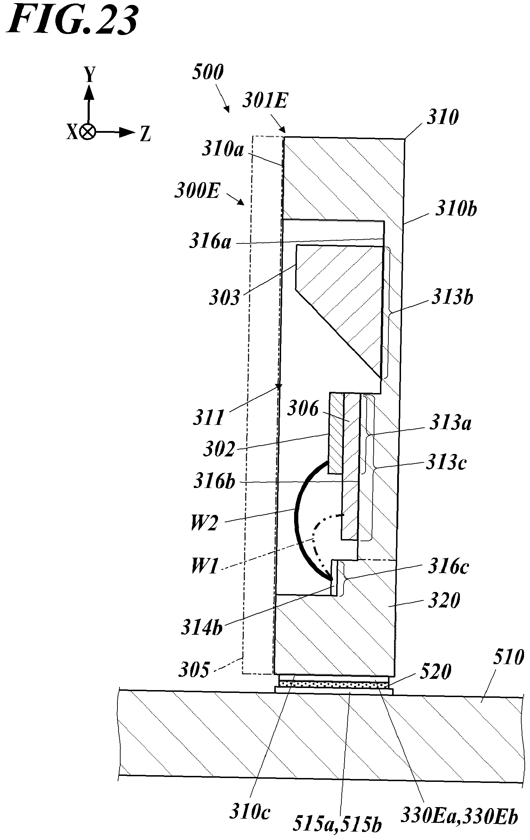

FIG. 21 is a vertical section showing a first example of an electronic module according to an embodiment. FIG. 22 is a vertical section showing a second example of the electronic module according to this embodiment. FIG. 23 is a vertical section showing a third example of the electronic module according to this embodiment. FIG. 21 and FIG. 22 show the examples each employing the electronic device 300A of the tenth embodiment. FIG. 23 shows the example employing the electronic device 300E of the twelfth embodiment.

An electronic module 500 of this embodiment includes the electronic device 300 (or any of the electronic devices 300A to 300E) and a module substrate 510. The module substrate 510 has connecting pads 515a, 515b. The wiring conductors 330a, 330b (or any of 330Aa to 330Ea and any of 330Ab to 330Eb) of the electronic device 300 (or any of the electronic devices 300A to 300E) are joined to the connecting pads 515a, 515b with a joining material 520, such as solder. In FIG. 21, the two connecting pads 515a, 515b are arranged on the front (near) side and the back (far) side of the paper surface.

In each of the electronic devices 300A to 300D having their respective mounting conductors 330Ac to 330Dc, as shown in FIG. 21, the mounting conductor 330Ac, 330Bc, 330Cc or 330Dc may be joined to a connecting pad 515c of the module substrate 510 with the joining material 520. Alternatively, as shown in FIG. 22, the mounting conductor 330Ac, 330Bc, 330Cc or 330Dc may be joined to a metal substrate portion 510c of the module substrate 510 with the joining material 520.

The electronic device 300E having the wiring conductors 330Ea, 330Eb on the side surface 310c may be, as shown in FIG. 23, mounted on the module substrate 510 such that the side surface 310c faces the substrate surface. That is, the wiring conductors 330Ea, 330Eb are joined to the connecting pads 515a, 515b of the module substrate 510 with the joining material 520, such as solder. According to this mounting method, light can be output from the electronic device 300E in a direction along the substrate surface.

According to the electronic module 500 of the embodiment, even if the amount of heat generated in the optical element 302 increases, it is possible to reduce the amount of heat that is conducted from the optical element 302 to the optical component 303, and can maintain the optical characteristics stably.

The optical element mounting packages 301 and 301A to 301E of the above embodiments can be manufactured by the same method as the first manufacturing method of an optical element mounting package described above.

In the above, embodiments of the present disclosure have been described. However, the above embodiments are merely examples. For example, in the above embodiments, a laser diode is used as the optical element, and a mirror is used as the optical component. However, the optical element may be replaced by various elements exemplified by a semiconductor laser element having separate light emitter and resonator, a non-semiconductor laser element, and an element that emits light other than laser light, such as a light emitting diode. Further, the optical component is not limited to a mirror, and various optical components may be used. The descriptions of the embodiments are illustrative in every aspect, and hence the present invention is not limited thereto. The present disclosure is applicable to the embodiments subjected to appropriate combination, change, replacement, addition, omission and/or the like of aspect(s) as far as there is no inconsistency. It is appreciated that not-shown numerous modifications can be envisaged without departing from the scope of the present invention.

### Industrial Applicability

The present disclosure is applicable to an optical element mounting package, an electronic device and an electronic module.

## Claims

1. An optical element mounting package comprising a base having
a recess including a first mounting portion where an optical element is mountable and a second mounting portion where an optical component is mountable, and
a heat radiating portion located opposite the second mounting portion with the first mounting portion in between.

2. The optical element mounting package according to claim 1,
wherein the base further has a sealing portion where a lid is to be connected, and
wherein the heat radiating portion is located outside the sealing portion if viewed in a depth direction of the recess.

3. The optical element mounting package according to claim 1 or 2, comprising a wiring conductor disposed on an upper surface of the heat radiating portion, with an open side of the recess as an upper side.

4. The optical element mounting package according to any one of claims 1 to 3, wherein a level difference is provided between the heat radiating portion and a portion of the base other than the heat radiating portion.

5. The optical element mounting package according to any one of claims 1 to 4, wherein with an open side of the recess as an upper side, the recess further includes a step portion located opposite the second mounting portion with the first mounting portion in between, the step potion being higher than the first mounting portion.

6. The optical element mounting package according to claim 5, further comprising an electrode to be electrically connected to the optical element, the electrode disposed on the step portion.

7. The optical element mounting package according to any one of claims 1 to 6, comprising a wiring conductor disposed on a bottom surface of the heat radiating portion, with an open side of the recess as an upper side.

8. The optical element mounting package according to any one of claims 1 to 7, further comprising a wiring conductor disposed on a surface of the heat radiating portion, the surface being opposite the recess.

9. The optical element mounting package according to any one of claims 1 to 8, wherein with an open side of the recess as an upper side, the heat radiating portion includes a lower portion that is a metal and an upper portion that is an insulator.

10. The optical element mounting package according to any one of claims 1 to 9, wherein the second mounting portion is inclined with respect to the sealing portion.

11. The optical element mounting package according to any one of claims 1 to 10, wherein of a side wall of the recess, a maximum thickness from an inner surface of a first side wall portion located opposite the second mounting portion with the first mounting portion in between to a surface on a protruding side of the heat radiating portion is at least twice a minimum wall thickness of the side wall of the recess excluding the first side wall portion.

12. The optical element mounting package according to claim 1, further wherein
the base has a first main surface,
the recess opens in the first main surface and further includes an electrode to be electrically connected to the optical element, the recess having:
a first inner bottom surface;
a first step portion closer to the first main surface than the first inner bottom surface in height; and
a second step portion included in the heat radiating portion, the second step portion being closer to the first main surface than the first step portion in height, located opposite the first inner bottom surface with the first step portion in between, and connected to an inner side surface of the recess,
the second mounting portion is located on the first inner bottom surface,
the first mounting portion is located on the first step portion, and
the electrode is located on the second step portion.

13. The optical element mounting package according to claim 12,
wherein the base has a second main surface located opposite the first main surface,
wherein the optical element mounting package further comprises a wiring conductor electrically connected to the electrode and disposed on the second main surface, and
wherein in a perspective plane viewed in a depth direction of the recess, the wiring conductor, the second step portion and the electrode lie on top of one another.

14. The optical element mounting package according to claim 12,
wherein the base has a second main surface located opposite the first main surface,
wherein the optical element mounting package further comprises a wiring conductor electrically connected to the electrode and disposed on the second main surface,
wherein the recess further includes a third mounting portion that is located on the first step portion and where a submount is to be mounted, the submount being interposed between the optical element and the first mounting portion, and
wherein in a perspective plane viewed in a depth direction of the recess, the wiring conductor and the third mounting portion lie on top of one another.

15. The optical element mounting package according to claim 12, further comprising a wiring conductor disposed on a first outer side surface of the base,
wherein the first outer side surface is located opposite the first step portion with the second step portion in between.

16. An electronic device comprising:
the optical element mounting package according to any one of claims 1 to 15;
the optical element mounted on the first mounting portion;
the optical component mounted on the second mounting portion; and
a lid joined to the optical element mounting package.

17. An electronic module comprising:
the electronic device according to claim 16; and
a module substrate where the electronic device is mounted.
